# EUROPEAN PATENT APPLICATION

(11) **EP 1 061 041 A1**
(43) Date of publication of application: **20.12.2000**
(21) Application number: 00304963.2
(22) Date of filing: 13.06.2000
(51) Int. Cl.: C01B 31/02, C23C 16/46, B01J 37/06, H01J 9/02

(54) **Low-temperature thermal chemical vapor deposition apparatus and method of synthesizing carbon nanotube using the same**

(30) Priority: 18.06.1999 KR 2304699; 27.04.2000 KR 0022525
(71) Applicant: Iljin Nanotech Co., Ltd., Seoul (KR); Lee, Cheol-jin, Gunsan-city, Jeonlabuk-do (KR)
(72) Inventor: Lee, Cheol-Jin, Gunsan-City, Jeonlabuk-do (KR); Yoo, Jae-Eun, Seongbuk-gu, Seoul (KR)
(74) Representative: Browne, Robin Forsythe, Dr.

(57) **Abstract**

A low-temperature chemical vapor deposition (CVD) apparatus and a method of synthesizing carbon nanotubes using the CVD apparatus. The thermal CVD apparatus includes: a reaction tube having a gas inlet portion and an exhaust portion, the reaction tube divided into a first region, which is spatially adjacent to the gas inlet portion, for thermally decomposing a gas entering through the gas inlet portion, and a second region, which is spatially adjacent to the exhaust portion, for synthesizing carbon nanotubes using the gas decomposed in the first region; a first resistance heater installed around the reaction tube, for maintaining the temperature of the first region at a first temperature; a second resistance heater installed around the reaction tube, for maintaining the temperature of the second region at a second temperature lower than the first temperature; and an insulator interposed between the first and second resistance heater for insulating the same. The carbon nanotube synthesis method includes forming a first metal catalyst film over a first substrate. The first metal catalyst film is etched with an etching gas to form a number of nano-sized catalytic particles, and a carbon source gas is thermally decomposed using a thermal chemical vapor deposition (CVD) apparatus having a reaction tube divided into first and second regions, maintained at different temperatures, wherein the carbon source gas is decomposed in the first region, which is a relatively high temperature region, of the reaction tube. Then, carbon nanotubes are synthesized over the catalytic particles using decomposed carbon source gas, in the second region whose temperature is lower than the first region.

## Description

### BACKGROUND OF THE INVENTION

### 1. Field of the Invention

The present invention relates to a method of synthesizing carbon nanotubes, and more particularly, to a method of synthesizing carbon nanotubes using thermal chemical vapor deposition (CVD).

### 2. Description of the Related Art

Carbon nanotubes have miniature cylindrical structures with a diameter on the order of a few nanometers and an aspect ratio of 10 to 1000. Carbon nanotubes have a honeycomb-like hexagon pattern in which each carbon atom is combined with three neighboring carbon atoms. Also, carbon nanotubes can function as either a conductor, like metals, or a semiconductor, according to their structures, and application fields of these carbon nanotubes are expected to be extensive.

To synthesize carbon nanotubes on a mass production scale, electrical discharging, laser deposition, and chemical vapor deposition using hydrocarbons have been widely used. In particular, the electrical discharging technique is to grow carbon nanotubes by arc discharge using a carbon electrode. The laser deposition method is to synthesize carbon nanotubes by irradiating graphite with laser light. However, these two methods are inappropriate for controlling the diameter and length of carbon nanotubes, and the structure of carbonaceous materials, and thus it is difficult to obtain excellent crystalline structure during the synthesis of carbon nanotubes. Furthermore, a large amount of amorphous carbon lumps are also produced at the same time, so that further complicate purification is necessary after the synthesis of the carbon nanotubes, thus complicating the process. Another drawback of these methods is that it is impossible to synthesize carbon nanotubes over a relatively wide area. Thus, these methods cannot be applied to a variety of devices.

A method of synthesizing carbon nanotubes by plasma CVD was suggested. However, carbon nanotubes can be damaged from plasma impact and synthesis of carbon nanotubes on a relatively large substrate is difficult.

Recently, a thermal CVD for synthesizing carbon nanotube on a substrate by thermal decomposition of hydrocarbon, has been disclosed. This existing thermal CVD technique is advantageous in that high purity carbon nanotubes can be produced on a large scale. However, the synthesis of carbon nanotubes by thermal CVD is carried out at a high temperature of 700°C or more, and thus a glass substrate cannot be applied for this method. For example, if a glass substrate cannot be used in the manufacture of display devices such as field emission displays, it will be unfavorable in view of technical and economical aspects. To use a glass substrate, the temperature of carbon nanotube synthesis must be equal to or less than 650°C at which deformation of glass is initiated. In another aspect, since almost all existing developed electronic devices have electrical interconnections, almost of which are formed of aluminum having a melting point of 700° C or less, the conventional thermal CVD method performed at 700° C or more is not applicable in the manufacture of the electronic devices.

### SUMMARY OF THE INVENTION

It is an objective of the present invention to provide a thermal chemical vapor deposition (CVD) apparatus in which high purity carbon nanotubes can be produced at low temperatures in a simple and economical way.

It is another objective of the present invention to provide a method of synthesizing carbon nanotubes using a low-temperature CVD method, which is applicable in the manufacture of display devices which adopt glass substrates, and electronic devices.

According to an aspect of the present invention, there is provided a thermal chemical vapor deposition (CVD) apparatus, comprising: a reaction tube having a gas inlet portion and an exhaust portion, the reaction tube divided into a first region, which is spatially adjacent to the gas inlet portion, for thermally decomposing a gas entering through the gas inlet portion, and a second region, which is spatially adjacent to the exhaust portion, for synthesizing carbon nanotubes using the gas decomposed in the first region; a first resistance heater installed around the reaction tube, for maintaining the temperature of the first region at a first temperature; a second resistance heater installed around the reaction tube, for maintaining the temperature of the second region at a second temperature lower than the first temperature; and an insulator interposed between the first and second resistance heater for insulating the same.

Preferably, the first and second resistance heaters are resistance coils. Preferably, the first region is maintained at a temperature of 700 to 1000°C by the first resistance heater, and the second region is maintained at a temperature of 450 to 650°C by the second resistance heater.

According to another aspect of the present invention, there is provided a method of synthesizing carbon nanotubes, comprising forming a first metal catalyst film over a first substrate. The first metal catalyst film is etched with an etching gas to form a number of nano-sized catalytic particles; thermally decomposing a carbon source gas using a thermal chemical vapor deposition (CVD) apparatus having a reaction tube divided into first and second regions, maintained at different temperatures, wherein the carbon source gas is decomposed in the first region, which is a relatively high temperature region, of the reaction tube. Then, carbon nanotubes are synthesized over the catalytic particles using decomposed carbon source gas, in the second region whose temperature is lower than the first region.

Preferably, the first substrate is formed of glass, quartz, silicon, alumina or silicon oxide. Preferably, the first metal catalyst film is formed of cobalt, nickel, iron or an alloy of the same. Preferably, the etching gas is ammonia gas, hydrogen gas or hydride gas. More preferably, ammonia gas is used as the etching gas.

Preferably, forming the catalytic particles is carried out in the second region of the reaction tube. Here, the second region is maintained at a temperature of 450 to 650°C.

In decomposing the carbon source gas, the first region may be maintained at a temperature of 700 to 1000°C. In synthesizing carbon nanotubes, the second region may be maintained at a temperature of 450 to 650°C.

A hydrocarbon gas having 1 to 20 carbon atoms may be used as the carbon source gas, and more preferably, acetylene or ethylene is used.

The carbon nanotube synthesis method may further comprise forming a second metal catalyst film over a second substrate, wherein forming the catalytic particles is carried out in a state where the first metal catalyst film and the second metal catalyst film face each other a predetermined distance apart. Preferably, synthesizing carbon nanotubes is carried out in a state where the catalytic particles face the second metal catalyst film a predetermined distance apart.

Preferably, the second metal catalyst film is formed of chromium or palladium.

The carbon nanotube synthesis method may further comprises forming an insulating film over the first substrate to prevent reaction between the first substrate and the first metal catalyst film. Preferably, the insulating film is formed of silicon oxide or alumina.

The carbon nanotube synthesis method according to the present invention may comprise forming a metal film over the first substrate. Preferably, the metal film is formed of titanium, titanium nitride, chromium or tungsten.

The present invention enables synthesis of carbon nanotubes with a high purity at a low temperature of 650° C or less, and thus a glass substrate having a low melting point can be used. Use of the present invention is highly effective in the manufacture of a variety of display devices including field emission displays (FEDs).

### BRIEF DESCRIPTION OF THE DRAWINGS

The above objectives and advantages of the present invention will become more apparent by describing in detail preferred embodiments thereof with reference to the attached drawings in which:
FIG. 1 is a schematic view showing the configuration of a preferred embodiment of a thermal chemical vapor deposition (CVD) apparatus according to the present invention;
FIGS. 2A through 2C are sectional views illustrating a method of synthesizing carbon nanotubes according to a first embodiment of the present invention;
FIG. 3 is a schematic view illustrating the synthesis of carbon nanotubes using the thermal CVD apparatus of FIG. 1;
FIG. 4 is an enlarged view showing a plurality of substrates put into slits of a quartz boat positioned at a low-temperature region in the reaction tube of the apparatus of FIG. 3;
FIG. 5 illustrates a second embodiment of the method of synthesizing carbon nanotubes according to the present invention,
FIGS. 6A through 6C are sectional views illustrating a third embodiment of the method of synthesizing carbon nanotubes according to the present invention; and
FIGS. 7A and 7B are sectional views illustrating a fourth embodiment of the method of synthesizing carbon nanotubes according to the present invention.

### DETAILED DESCRIPTION OF THE INVENTION

The present invention will now be described more fully with reference to the accompanying drawings, in which preferred embodiments of the invention are shown. This invention may, however, be embodied in many different forms and should not be construed as being limited to the embodiments set forth herein. Rather, these embodiments are provided so that this disclosure will be thorough and complete, and will fully convey the concept of the invention to those skilled in the art. In the drawings, the thickness of layers and regions are exaggerated for clarity. It will also be understood that when a layer is referred to as being "on" another layer or substrate, it can be directly on the other layer or substrate, or intervening layers may also be present.

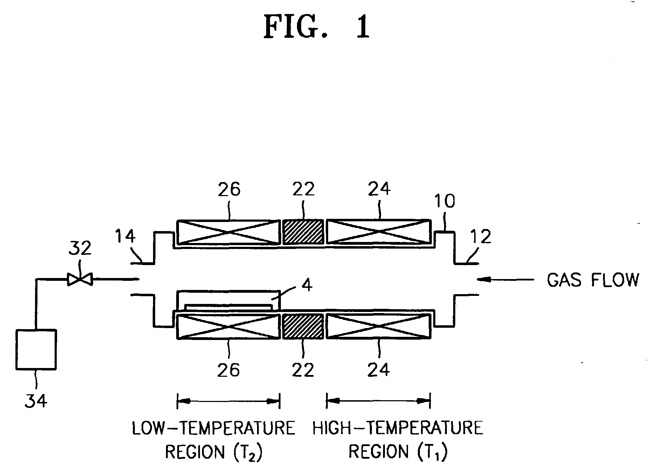

The structure of a low-temperature thermal chemical vapor deposition (CVD) apparatus according to a preferred embodiment of the present invention is shown in FIG. 1. Referring to FIG. 1, the low-temperature CVD apparatus includes a reaction tube 10 made of quartz. The reaction tube 10 is divided into two regions, i.e., a high-temperature region and a low-temperature region, in its longitudinal direction.

A first resistance heater 24 is installed around the reaction tube 10 near a gas inlet portion 12, such that the high-temperature region located near the gas inlet portion 12 is maintained at a first temperature T₁, which is relatively high, by the first resistance heater 24.

A second resistance heater 26 is installed around the reaction tube 10 near an exhaust portion 24, such that the low-temperature region located near the exhaust portion 14 is maintained at a second temperature T₂, which is lower than the first temperature T₁, by the second resistance heater 26.

The first and second resistance heaters 24 and 26 are separated from each other by an insulator 22. The first and second resistance heaters 24 and 26 may be constructed in coil forms.

A thermocouple (not shown) is installed in both the high- and low-temperature regions of the reaction tube 10, to sense the temperature of the two regions. Preferably, the temperature of the high-temperature region of the reaction tube 10 is kept in the range of 700 to 1000°C by the first resistance heater 24, and the temperature of the low-temperature region is kept in the range of 450 to 650°C by the second resistance heater 26.

Also, a pump 32 and an exhaust device 34 are set near the exhaust portion 14 of the reaction tube 10, as shown in FIG. 1. The inner pressure of the reaction tube 10 can be adjusted by the exhaust device 34.

A gas entering the reaction tube 10 through the gas inlet portion 12 flows through the high- and low-temperature regions, in sequence, within the reaction tube 10, and is exhausted through the exhaust portion 14. The reaction gas allowed to flow into the reaction tube 10 is decomposed by heat at the high-temperature region. As the decomposed reaction gas migrates to the low-temperature region of the reaction tube 10, carbon nanotubes are synthesized in the low-temperature region.

Thus, to perform a CVD process in the low-temperature thermal CVD apparatus according to the present invention, a quartz boat 4, which holds a target substrate to be subjected to deposition, must be positioned in the low-temperature region of the reaction tube 10.

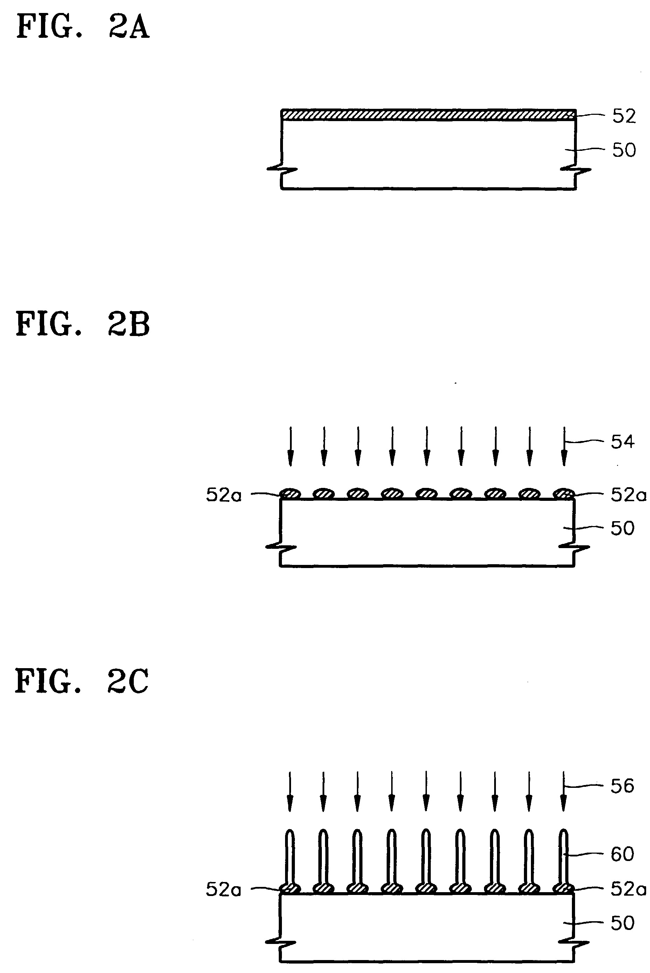

FIGS. 2A through 2C are sectional views illustrating a method of synthesizing carbon nanotubes according to a first embodiment of the present invention. In the present embodiment, the low-temperature thermal CVD apparatus shown in FIG. 1 is used.

Referring to FIG. 2A, first a metal catalyst film 52 is formed over a substrate 50 to have a thickness of about 2 to 200 nm. The substrate 50 is formed of a material, which neither reacts during CVD nor reacts with metals, for example, glass, quartz, silicon, alumina (Al₂O₃) or silicon oxide. The metal catalyst film 52 can be formed of, for example, cobalt (Co), nickel (Ni), iron (Fe) or an alloy of the same, by a common thermal deposition, E-beam deposition or sputtering method.

FIG. 2B illustrates formation of a number of catalytic particles from the metal catalyst film 52 in the low-temperature thermal CVD apparatus of FIG. 1.

First, the substrate 50 with the metal catalyst film 52 is inserted partially upright into a slit of the quartz boat 4, and loaded into the low-temperature region of the reaction tube 10 of the thermal CVD apparatus shown in FIG. 1. Here, the temperature of the high-temperature region of the reaction tube 10 is maintained in the range of 700 to 1000°C by the first resistance heater 24, while the temperature of the low-temperature region is maintained in the range of 450 to 650°C by the second resistance heater 26. Also, the inner pressure of the reaction tube 10 is kept at a few hundred mTorr to a few Torr.

Then, an etching gas 54 is supplied into the reaction chamber 10 through the gas inlet portion 12. The etching gas 54 may be ammonia gas, hydrogen gas or hydride gas such as NH. An ammonia gas is more preferred as the etching gas. When ammonia gas is used as the etching gas, the flow rate is controlled to be between about 80 and 300 sccm.

As a result, the metal catalyst film 52 is etched from the surface along grain boundaries within the same, which results in a number of catalytic particles 52a, which are nano-sized catalytic metal islands, on the surface of the substrate 50. The catalytic particles 52a serve as a catalyst in the synthesis of carbon nanotubes.

FIG. 2C illustrates a step of synthesizing carbon nanotubes 60. When the formation of a number of catalytic particles 52a over the substrate 50 is completed, a carbon source gas 56 is supplied through the gas inlet portion 12 into the reaction tube 10. The carbon source gas 56 may be any gas capable of forming carbon dimer and having a low decomposition temperature. A hydrocarbon gas having 1 to 20 carbon atoms is preferred as the carbon source gas 56, but acetylene or ethylene gas is more preferred. The carbon source gas 56 is supplied at a flow rate of about 20 to 100 sccm for about 10 to 40 minutes.

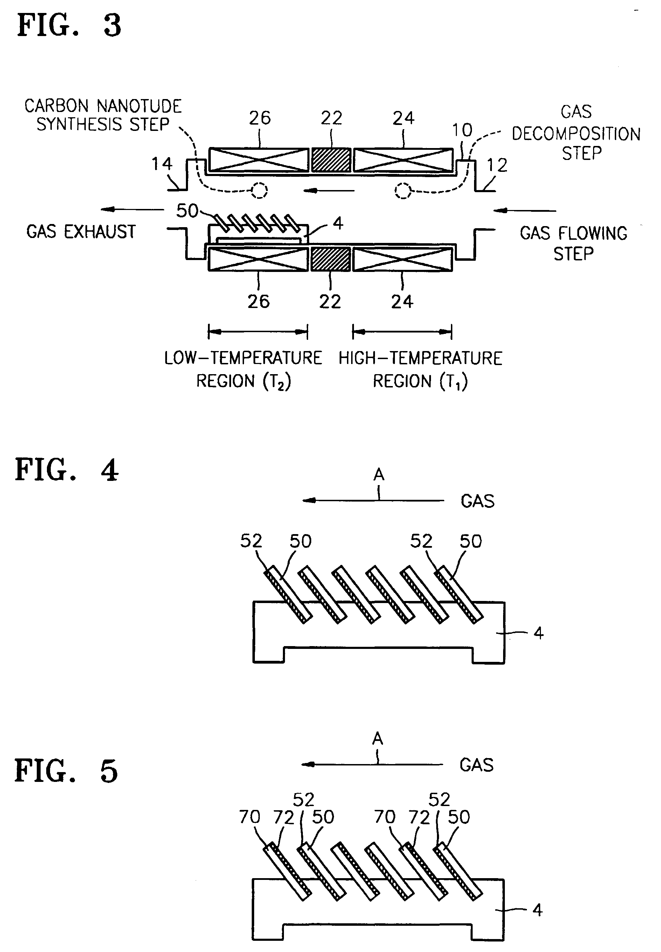

FIG. 3 is a schematic view illustrating the process of forming carbon nanotubes 60 from the flowing of the carbon source gas 56 into the reaction tube 10 to the synthesis of carbon nanotubes 60 in the low-temperature thermal CVD apparatus shown in FIG. 1.

As shown in FIG. 3, the carbon source gas 56 entering into the reaction tube 10 through the gas inlet portion 12 is decomposed at the high-temperature region, which is maintained at about 700 to 1000°C, and high purity carbon nanotubes 60 are synthesized on the catalytic particles 52 by the decomposed carbon source gas 56 at the low-temperature region, which is maintained at about 450 to 650°C. Here, the catalytic particles 52a serve as a catalyst for the growth of carbon nanotubes 60.

FIG. 4 is an enlarged view of a plurality of substrates 50 put into the slits of the quartz boat 4 positioned at the low-temperature region in the reaction tube 10 of FIG. 3. As shown in FIG. 4, the substrate 50 are inserted into the slits of the quartz boat 4 such that the metal catalyst film 52 formed over the substrate 50 does not face the gas flowing in the direction indicated by arrow A.

FIG. 5 is a diagram illustrating a second embodiment of the method of synthesizing carbon nanotubes according to the present invention. In the second embodiment, the metal catalyst film 52 is formed over the substrate 50 as in the first embodiment, which was described earlier with reference to FIG. 2A. Unlike the first embodiment, the first substrates 50 are positioned into the slits of the quartz boat 4 as in the previous embodiment illustrated in FIG. 4, but one slit apart, and then the empty slits of the quartz boat 4 are filled with second substrates 70 having a metal catalyst film 72 over the surface, such that the metal catalyst films 52 and 72 face each other a predetermined distance apart.

The second substrate 70 can be formed of, for example, glass, quartz, silicon, alumina (Al₂O₃) or silicon oxide. It is preferable that the metal catalyst film 72 formed over the second substrate 70 is formed of chromium (Cr) or palladium (Pd).

Then, the etching gas 54 and the carbon source gas 56 are supplied, in sequence, into the reaction tube 10 as in the previous embodiment described with reference to FIGS. 2B and 2C, to form carbon nanotubes over the first substrate 50. Here, when the etching gas 54 and the carbon source gas 56 are supplied into the reaction tube 10, a constituent of the metal catalyst film 72 acts as a catalyst of further reducing the decomposition temperature of the etching gas 54 and the carbon source gas 56 within the low-temperature region of the reaction tube 10.

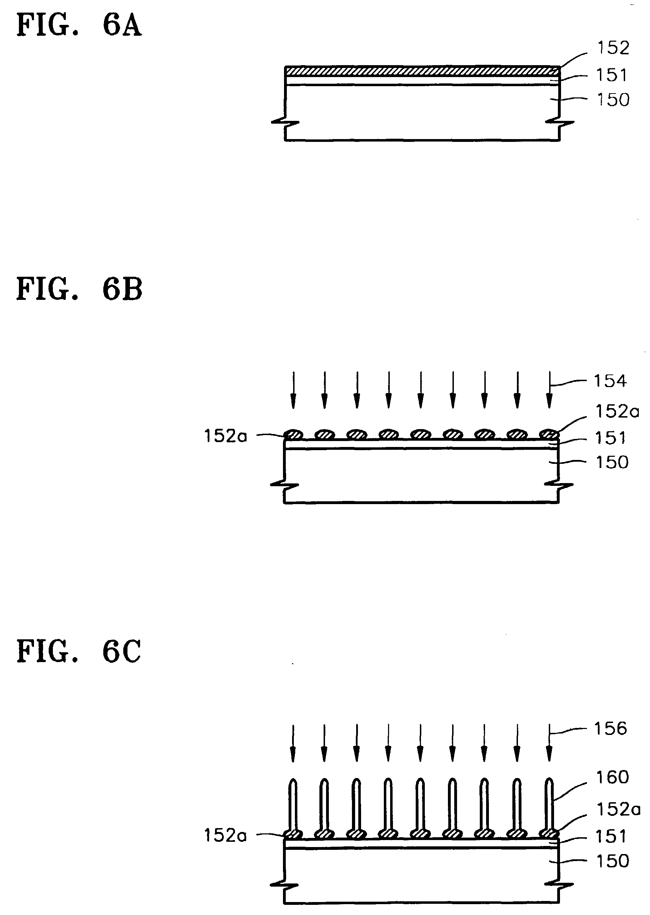

FIGS. 6A through 6C are sectional views illustrating a third embodiment of the method of synthesizing carbon nanotubes according to the present invention. In the third embodiment, the low-temperature thermal CVD apparatus shown in FIG. 1 is used.

Referring to FIG. 6A, first an insulating film 151 is formed over a substrate 150. Then, a metal catalyst film 152 is formed over the insulating film 151 as in the first embodiment described with reference to FIG. 2A. The formation of the insulating film 151 is to prevent a reaction between a metal of the metal catalyst film 152 and constituents of the substrate 150. For example, in the case where the substrate 150 is a silicon substrate and the metal catalyst film 152 is formed of Co. Ni or an alloy of the same, the insulating film 151 is formed between the metal catalyst film 152 and the substrate 150 to prevent formation of silicide at the interface. The insulating layer 151 may be formed of, for example, silicon oxide or alumina (Al₂O₃).

Referring to FIG. 6B, an etching gas 154 is supplied into the thermal CVD apparatus to etch the metal catalyst film 152 to form a number of catalytic particles 152a, as in the first embodiment described with reference to FIG. 2B. Then, the thermal CVD deposition is carried out, as in the first embodiment illustrated with reference to FIGS. 2C and 3, on the structure having the catalytic particles 152, by flowing a carbon source gas 156 into the apparatus, which results in high purity carbon nanotubes 160 formed protruding from the catalytic particles 152a, as shown in FIG. 6C.

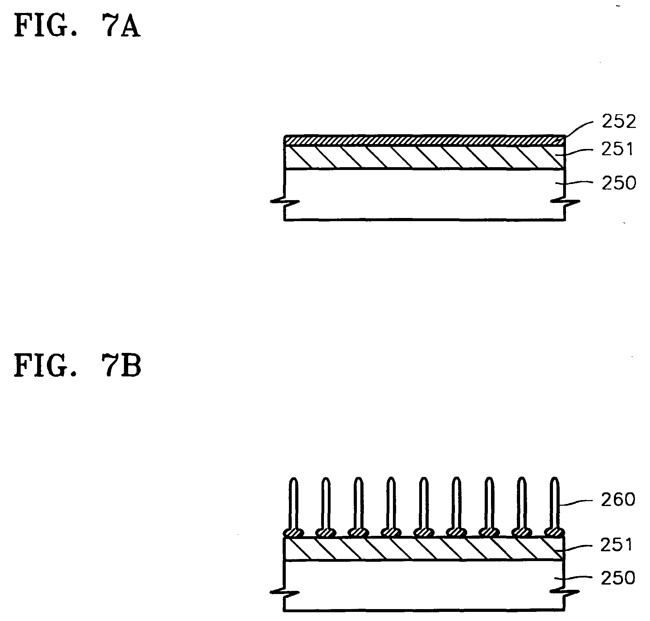

FIGS. 7A and 7B are sectional views illustrating a fourth embodiment of the method of synthesizing carbon nanotubes according to the present invention. The fourth embodiment involves the further formation of a metal film 251 between a substrate 250 and a metal catalyst film 252. In particular, the metal film 251 is formed over the substrate 250 with, for example, titanium (Ti), titanium nitride, chromium (Cr) or tungsten (W), and then the metal catalyst film 252 is formed over the metal film 251. Then, the processes described with reference to FIGS. 2B, 2C and 3 are performed to form carbon nanotubes 260. The metal film 251 can be used for electrodes for such devices as FEDs, vacuum fluorescent displays (VFD) or white light sources.

In the drawings and specification, typical preferred embodiments of the invention are disclosed and, although specific terms are employed, they are used in a generic and descriptive sense only and not for purposes of limitation.

The low-temperature thermal CVD apparatus according to the present invention has a reaction tube, which is compartmented into two regions, wherein the temperatures of the two regions, high- and low-temperature regions, are independently controlled by two different resistance heaters separated by an insulator. Thus, in the method of synthesizing carbon nanotubes according to the present invention, using the low-temperature thermal CVD apparatus, a reaction gas entering the apparatus is decomposed in the high-temperature region and carbon nanotubes are synthesized over a number of catalytic particles formed over the substrate in the low-temperature region.

As previously described, in contrast to a conventional thermal CVD technique which grows carbon nanotubes at high temperatures, the present invention can produce carbon nanotubes at a low temperature of 650°C or less, with a high purity. Thus, the present invention is effectively applicable to glass substrates having a low melting point. Also, according to the present invention, high purity carbon nanotubes can be densely synthesized over a relatively large flat substrate at a low temperature. Thus, the present invention is effectively applicable to the manufacture of various display devices including FEDs.

While this invention has been particularly shown and described with reference to preferred embodiments thereof, it will be understood by those skilled in the art that various changes in form and details may be made thereto without departing from the spirit and scope of the invention as defined by the appended claims.

## Claims

1. A thermal chemical vapor deposition (CVD) apparatus, comprising:
a reaction tube having a gas inlet portion and an exhaust portion, the reaction tube divided into a first region, which is spatially adjacent to the gas inlet portion, for thermally decomposing a gas entering through the gas inlet portion, and a second region, which is spatially adjacent to the exhaust portion, for synthesizing carbon nanotubes using the gas decomposed in the first region;
a first resistance heater installed around the reaction tube, for maintaining the temperature of the first region at a first temperature;
a second resistance heater installed around the reaction tube, for maintaining the temperature of the second region at a second temperature lower than the first temperature; and
an insulator interposed between the first and second resistance heater for insulating the same.

2. The apparatus of claim 1, wherein the first and second resistance heaters are resistance coils.

3. The apparatus of claim 1, wherein the first region is maintained at a temperature of 700 to 1000°C by the first resistance heater, and the second region is maintained at a temperature of 450 to 650°C by the second resistance heater.

4. A method of synthesizing carbon nanotubes, comprising:
forming a first metal catalyst film over a first substrate;
etching the first metal catalyst film with an etching gas to form a number of nano-sized catalytic particles;
thermally decomposing a carbon source gas using a thermal chemical vapor deposition (CVD) apparatus having a reaction tube divided into first and second regions, maintained at different temperatures, wherein the carbon source gas is decomposed in the first region, which is a relatively high temperature region, of the reaction tube; and
synthesizing carbon nanotubes over the catalytic particles using decomposed carbon source gas, in the second region whose temperature is lower than the first region.

5. The method of claim 4, wherein the first substrate is formed of glass, quartz, silicon, alumina or silicon oxide.

6. The method of claim 4, wherein the first metal catalyst film is formed of cobalt, nickel, iron or an alloy of the same.

7. The method of claim 4, wherein the first metal catalyst film is formed to have a thickness of 2 to 200 nm.

8. The method of claim 4, wherein the etching gas is ammonia gas, hydrogen gas or hydride gas.

9. The method of claim 8, wherein the etching gas is ammonia gas.

10. The method of claim 4, wherein forming the catalytic particles is carried out in the second region of the reaction tube.

11. The method of claim 10, wherein the second region is maintained at a temperature of 450 to 650°C.

12. The method of claim 4, wherein, in decomposing the carbon source gas, the first region is maintained at a temperature of 700 to 1000°C.

13. The method of claim 4, wherein the carbon source gas is a hydrocarbon gas having 1 to 20 carbon atoms.

14. The method of claim 13, wherein the carbon source gas is acetylene or ethylene.

15. The method of claim 4, wherein, in synthesizing carbon nanotubes, the second region is maintained at a temperature of 450 to 650°C.

16. The method of claim 4, further comprising forming a second metal catalyst film over a second substrate,
wherein forming the catalytic particles is carried out in a state where the first metal catalyst film and the second metal catalyst film face each other a predetermined distance apart.

17. The method of claim 16, wherein synthesizing carbon nanotubes is carried out in a state where the catalytic particles face the second metal catalyst film a predetermined distance apart.

18. The method of claim 16, wherein the second substrate is formed of glass, quartz, silicon, alumina or silicon oxide.

19. The method of claim 17, wherein the second substrate is formed of glass, quartz, silicon, alumina or silicon oxide.

20. The method of claim 16, wherein the second metal catalyst film is formed of chromium or palladium.

21. The method of claim 17, wherein the second metal catalyst film is formed of chromium or palladium.

22. The method of claim 4, further comprising forming an insulating film over the first substrate to prevent reaction between the first substrate and the first metal catalyst film,
wherein the first catalytic film is formed over the insulating film.

23. The method of claim 22, wherein the insulating film is formed of silicon oxide or alumina.

24. The method of claim 4, further comprising forming a metal film over the first substrate,
wherein the first metal catalyst film is formed over the metal film.

25. The method of claim 24, wherein the metal film is formed of titanium, titanium nitride, chromium or tungsten.
